# EUROPÄISCHE PATENTSCHRIFT

(11) **EP 2 873 296 B1**
(45) Veröffentlichungstag und Bekanntmachung des Hinweises auf die Patenterteilung: **11.05.2016**
(21) Anmeldenummer: 13736490.7
(22) Anmeldetag: 10.07.2013
(51) Int. Cl.: H05B 3/24, H05K 9/00, B32B 37/12, B32B 37/18

(54) **WÄRME ERZEUGENDES ELEMENT**
HEAT GENERATING ELEMENT
ÉLÉMENT CHAUFFANT

(30) Priorität: 11.07.2012 DE 102012013770
(43) Veröffentlichungstag der Anmeldung: 20.05.2015
(73) Patentinhaber: Eberspächer catem GmbH & Co. KG, 76863 Herxheim (DE)
(72) Erfinder: BOHLENDER, Franz, 76870 Kandel (DE); REISS, Holger, 76764 Rheinzabern (DE); NIEDERER, Michael, 76889 Kapellen-Drusweiler (DE); MORGEN, Christian, 76887 Bad Bergzabern (DE)
(74) Vertreter: Grünecker Patent- und Rechtsanwälte PartG mbB
(86) Internationale Anmeldenummer: PCT/EP2013/002038
(87) Internationale Veröffentlichungsnummer: WO 2014/009013

(56) Entgegenhaltungen:
- EP-A1- 0 262 243
- EP-A1- 1 768 458
- EP-A1- 1 916 873
- GB-A- 1 583 771
- US-A- 4 371 777

## Beschreibung

Die vorliegende Erfindung betrifft ein Wärme erzeugendes Element, insbesondere für eine elektrische Heizvorrichtung eines Kraftfahrzeuges, vorzugsweise mit einem Positionsrahmen, der eine Aufnahme ausbildet, in dem wenigstens ein PTC-Element aufgenommen ist, und zwei an gegenüberliegenden Seiten des PTC-Elementes anliegenden Kontaktblechen.

Solche Wärme erzeugenden Elemente sind allgemein bekannt als Bestandteil einer elektrischen Heizvorrichtung insbesondere zur Lufterwärmung in einem Kraftfahrzeug, die mit der vorliegenden Erfindung ebenfalls weitergebildet werden soll. Das Wärme erzeugende Element bildet eine Lage eines Schichtaufbaus, welches üblicherweise an beiden Seiten des Wärme erzeugenden Elementes anliegende Wellrippenelemente umfasst. Dieser Schichtaufbau hat üblicherweise eine Mehrzahl von jedenfalls in einer Ebene übereinander geschichteten Lagen von Wellrippenelementen und Wärme erzeugenden Elementen.

Ein gattungsgemäßes Wärme erzeugendes Element ist aus der EP 2 190 256 A1 bekannt. Bei diesem Stand der Technik werden außen an dem Wärme erzeugenden Element anliegende Wellrippen mit dem Wärme erzeugenden Element verklebt. Hierzu wird ein aushärtender isolierender Kleber, wie beispielsweise Silikon, in Freiräume innerhalb des Positionsrahmens eingebracht, der die verbleibenden Freiräume ausfüllt, so dass das Innere des Positionsrahmens durch den isolierenden ausgehärteten Kleber hermetisch gegenüber der Umgebung abgedichtet sein soll. Der aushärtende Kleber gelangt auch an die Phasengrenze zwischen dem Wärme erzeugenden Element und den Wellrippenelementen, so dass diese Wellrippenelemente nach dem Aushärten des Klebers mit dem Wärme erzeugenden Element verbunden sind. Es ergibt sich ein in sich geschlossener Heizstab, der als solcher gehandhabt und in eine elektrische Heizvorrichtung eingelegt bzw. eingebaut werden kann.

Der Lösungsvorschlag nach der EP 2 190 256 A1 hat gewisse Nachteile. So kommt es beim Betrieb des Wärme erzeugenden Elementes zu Wärmeausdehnungen. Aufgrund der unterschiedlichen Beschaffenheit der Bauteile, die das Wärme erzeugende Element bilden, kommt es zu unterschiedlichen Wärmedehnungen. Der erhärtete isolierende Kleber kann die unterschiedlichen Dehnungsbeträge nicht zuverlässig nachführen. Es kommt dauerhaft zu einer Rissbildung, so dass die gewünschte Versiegelung des Wärme erzeugenden Elementes durch den ausgehärteten Kleber verlorengeht.

Elektrische Heizvorrichtungen umfassend ein Wärme erzeugendes Element der gattungsgemäßen Art führen mitunter zu elektromagnetischen Störungen, die insbesondere innerhalb eines Kraftfahrzeuges unerwünscht sind, da sich diese beispielsweise beim Betrieb eines Radios akustisch im Fahrzeuginnenraum bemerkbar machen.

Die vorliegende Erfindung geht insbesondere von einem Wärme erzeugenden Element aus, wie es aus der EP 2 395 295 A1 bekannt ist. Dieser Stand der Technik zeigt mit seinem Ausführungsbeispiel nach den Figuren 12 bis 14 ein Wärme erzeugendes Element für eine elektrische Heizvorrichtung eines Kraftfahrzeuges mit zwei schalenförmigen Abschirmblechen, wobei die schalenförmigen Abschirmbleche in dem Stand der Technik einen im Wesentlichen U-förmigen Querschnitt haben. Die schalenförmigen Abschirmbleche bilden indes lediglich eine randseitige Umschließung nach Art eines Rohres aus, welches an den Stirnseiten offen ist. Eine vollumfängliche Abschirmung ergibt sich erst durch Endstücke, die endseitig auf die freien Enden des Rohres aufgesteckt sind. Die beiden Halbschalen können nach der Offenbarung der EP 2 395 295 A1 aus Metall gebildet und nach dem Fügen mittels Kleben verbunden werden.

Der vorliegenden Erfindung liegt das Problem zugrunde, ein Wärme erzeugendes Element insbesondere für eine elektrische Heizvorrichtung für ein Kraftfahrzeug anzugeben, welches in verbesserter Weise der EMV-Problematik Rechnung trägt und sicher gegenüber der Umgebung isoliert und vor dem Eintreten von Umwelteinflüssen geschützt ist. Des Weiteren will die vorliegende Erfindung ein Verfahren zur Herstellung eines solchen Wärme erzeugenden Elementes angeben.

Zur Lösung des vorrichtungsmäßigen Problems wird mit der vorliegenden Erfindung ein Wärme erzeugendes Element mit den Merkmalen von Anspruch 1 angegeben. Dieses Wärme erzeugende Element hat eine Abschirmung, welche durch das Wärme erzeugende Element und dessen Betrieb begründete elektromagnetische Strahlungen abschirmt. Dementsprechend sind die elektrisch leitenden Kontaktbleche wie auch das PTC-Element des Wärme erzeugenden Elementes durch die Abschirmung eingehaust. Die Abschirmung hat keinen direkten elektrischen Kontakt zu den Strom führenden Elementen des Wärme erzeugenden Elementes, d.h. den Kontaktblechen und dem wenigsten einen PTC-Element. Die die Abschirmung bildenden Bleche sind dementsprechend üblicherweise elektrisch von den Strom führenden Elementen isoliert.

Die Abschirmung des erfindungsgemäßen Wärme erzeugenden Elementes wird zumindest durch ein erstes und ein zweites Abschirmblech gebildet. Diese Abschirmbleche sind an der Außenseite der zugeordneten Isolierschicht vorgesehen. Es können zwar mehr als zwei Abschirmbleche vorgesehen sein, die üblicherweise insgesamt elektrisch miteinander gekoppelt, d.h. elektrisch leitend miteinander verbunden sind. Üblicherweise werden indes aus fertigungstechnischen Gründen allein zwei Abschirmbleche verwendet.

Mit Blick auf eine gute Abfuhr und damit einen hohen Wirkungsgrad des PTC-Elementes sind die ersten und zweiten Abschirmbleche Wärme leitend mit der Isolierschicht gekoppelt, die wiederum üblicherweise unmittelbar an dem zugehörigen Kontaktblech anliegt. Es ergibt sich dementsprechend vorzugsweise ein Schichtaufbau mit den innen liegen PTC-Elementen, an gegenüberliegenden Seiten daran anliegenden Kontaktblechen und an deren Außenseite wiederum direkt anliegenden Isolierschichten. Diese Isolierschichten können aus Keramik und/oder Kunststofffolie gebildet sein. Besonders bevorzugt ist eine Folie aus Polyimid oder Silikon. Der Schichtaufbau hat an seiner Außenseite wiederum die ersten und zweiten Abschirmbleche. Dabei haben die ersten und zweiten Abschirmbleche eine zumindest schalenförmige Ausgestaltung, so dass die gefügten Abschirmbleche ein gegebenenfalls endseitig noch offenes Rohr ausbilden, welches durch weitere die Abschirmung stirnseitig vervollständigende Endkappen geschlossen sein kann. Vorzugsweise haben die Abschirmbleche indes eine wannenförmige Ausgestaltung mit einem im Wesentlichen umfänglich umlaufenden Rand, der das üblicherweise längliche und mehrere PTC-Elemente in Längsrichtung hintereinander angeordnet aufweisende Wärme erzeugende Element auch randseitig übergreift. Der umbogene Rand der beiden wannenförmig ausgebildeten Abschirmbleche umgreift dementsprechend einen Teil des Positionsrahmens.

Die beiden Abschirmbleche sind vorzugsweise so ausgebildet, dass sie einen Überlappungsbereich haben, in dem die Abschirmbleche jeweils an dem Rand unmittelbar benachbart zueinander, miteinander kontaktiert und zweilagig vorgesehen sind. Bei wannenförmigen Abschirmblechen ergibt sich ein in Umfangsrichtung umlaufender Überlappungsbereich. Bei schalenförmigen Ausgestaltungen ergibt sich der Überlappungsbereich an den gegenüberliegenden Längsseiten. Eine wannenförmige Ausgestaltung ist eine schalenförmige Ausgestaltung mit stirnseitigen, d.h. an gegenüberliegenden Enden des Rohres vorgesehenen Rändern. In dem Überlappungsbereich sind die Abschirmbleche üblicherweise elektrisch miteinander kontaktiert, so dass sich eine vollumfängliche Abschirmung für das PTC-Element und die beiden daran anliegenden Kontaktbleche ergibt. Es können im Überlappungsbereich nur wenige Kontaktstellen zur Kontaktierung der beiden Abschirmbleche vorgesehen sein. Bevorzugt stoßen diese im Falle eines Stoßbereiches über einen überwiegenden Teil ihrer stirnseitigen Länge direkt aneinander. Bei einem Überlappungsbereich übergreifen die Abschirmbleche einander in Höhenrichtung. Durch die wannenförmige Ausgestaltung haben beide Abschirmbleche Längswandabschnitte, die sich im Wesentlichen in Höhenrichtung des PTC-Elementes erstrecken. Die Längswandabschnitte sind umfänglich umlaufend ausgeformt und erfahren vorzugsweise lediglich dort eine Durchbrechung, wo Kontaktstifte von außen bis zu den Kontaktblechen geführt sind, um das Wärme erzeugende Element elektrisch anzuschließen. Im Überlappungsbereich ist der Längswandabschnitt eines der Abschirmbleche, welches im Nachfolgenden auch als unteres Abschirmblech bezeichnet wird, nach außen ausgestellt und bildet dementsprechend eine Aufnahme für den Längswandabschnitt des anderen Abschirmblechs aus. In diesem Überlappungsbereich kontaktieren sich die Abschirmbleche üblicherweise. Das freie Ende des ausgestellten Längswandabschnittes hat vorzugsweise eine nach außen trichterförmig ausgeformte Ausgestaltung, so dass der Positionsrahmen und auch das andere, regelmäßig zweite Abschirmblech leicht in das untere, erste Abschirmblech eingebracht werden können.

Weiterhin erfindungsgemäß sind die Abschirmbleche im Überlappungsbereich durch einen Kleber versiegelt. Dieser aushärtende Kleber dichtet zumindest das erste Abschirmblech gegenüber dem zweiten Abschirmblech ab. Wegen der gewünschten Kontaktierung der beiden Abschirmbleche und mit Blick auf eine sichere Versiegelung befindet sich ein überwiegender Teil, vorzugsweise sämtlicher aushärtender Kleber im Innern der Abschirmung und siegelt das bzw. die freien Enden der Abschirmbleche ein. Der Kleber ist vorzugsweise ein Silikonkleber, der eine gewisse Elastizität hat und darüber hinaus gute elektrisch isolierende Eigenschaften. Der Kleber wird aufgrund seiner Elastizität vorzugsweise zur Ausfüllung eines bestimmten Kammervolumens so eingebracht, dass der Kleber nicht als dünner Film aushärtet, sondern sich ein in Umfangsrichtung umlaufender und durch den Kleber gebildeter wulstartiger Dichtstreifen ergibt.

Dieser wulstartige aus Kleber gebildete Dichtstreifen, der auch als Kleberaupe bezeichnet werden kann, bietet ein gewisses Volumen, in welches ein Rand des üblicherweise innen vorgesehenen Abschirmbleches eintaucht und somit das innerhalb der Abschirmung vorgesehene Volumen gegenüber der Atmosphäre abdichtet. Dabei liegt der Rand des inneren Abschirmblechs, der in den Kleber eingetaucht ist, üblicherweise jedenfalls auch an der Innenwandung des äußeren schalenförmigen Abschirmblechs an. Mit Blick auf eine besonders gute und zuverlässige Abdichtung kann indes das vordere Ende des Randes, des inneren Abschirmblechs nach innen umbogen und somit sowohl an dem Innenumfang des umlaufenden Randes elektrisch leitend angelegt wie auch am Außenumfang sicher in die Kleberaupe eingetaucht sein.

Zur Ausbildung eines geeignet großen Kammervolumens ist der umfängliche Außenrand an einen es vorzugsweise vorgesehenen Positionsrahmens mit zumindest einer Aufnahme für das wenigstens eine PTC-Element angepasst. Üblicherweise ist der Positionsrahmen an den zwischen dem Positionsrahmen und der Abschirmung vorgegebenen Freiraum eingepasst. Der Positionsrahmen ist vorzugsweise so ausgebildet, dass er am äußeren Rand ganz oder teilweise nach hinten verspringt, so dass eine Kammer ausgebildet wird, in welcher der Kleber mit dem notwendigen Volumen eingebracht werden kann.

Mit Blick auf möglichst gute Kriech- und Luftstrecken, die insbesondere bei dem Betrieb der elektrischen Heizvorrichtung unter Hochvoltbedingungen, beispielsweise in einem Elektrofahrzeug bedeutsam sind, ist darauf zu achten, dass die elektrifizierten Teile des Wärme erzeugenden Elementes einen hinreichenden Abstand zu den nicht elektrifizierten und isolierenden Teilen haben. So berührt der ausgehärtete Kleber vorzugsweise keine freiliegenden Oberflächen der Kontaktbleche und des PTC-Elementes. Als freiliegende Oberflächen werden insbesondere die die PTC-Elemente übergreifenden Ränder der Kontaktbleche sowie die Stirnseitenflächen des PTC-Elementes angesehen, die sich zwischen den beiden Kontaktblechen erstrecken. Auch die stirnseitigen Randflächen der Kontaktbleche liegen üblicherweise frei. Dazu hat der Positionsrahmen regelmäßig einen gestuften Aufbau, der so ausgeklinkt ist, dass die Kontaktbleche mit ihrem freien, das bzw. die PTC-Elemente überragenden Rand zwar einen Teil des Positionsrahmens überdecken, jedoch nicht auf dem Positionsrahmen anliegen bzw. stirnseitig dagegen stoßen. Eine oder beide Isolierschichten können mit einem Kleber, insbesondere mit dem aushärtenden Kleber mit dem Positionsrahmen verbunden sein. Eine Isolierschicht kann auch beispielsweise unmittelbar durch Umspritzen des den Positionsrahmen bildenden Kunststoffs mit diesem verbunden sein. Die Kontaktblechen können auf die zugehörigen Isolierschichten entweder lediglich aufgelegt oder zusätzlich mit diesen verklebt sein. Auch durch das alleinige Auflegen der Schichten des Wärme erzeugenden Elementes aufeinander kann eine hinreichende Positionierung der Kontaktbleche und der PTC-Elemente relativ zu dem Positionsrahmen erreicht werden, wenn durch die Verbindung der beiden Abschirmbleche der innerhalb der Abschirmbleche liegende Schichtaufbau unter Druckspannung gehalten wird.

Zur bestmöglichen Anordnung des Klebers in einer Kammer zwischen dem stirnseitigen Rand des Positionsrahmens und dem ersten und dem zweiten Abschirmblech derart, dass der Kleber zumindest diese drei Elemente gegebenenfalls noch eine oder zwei Isolierschichten miteinander verklebt, wird der Außenrand des Positionsrahmens vorzugsweise besonders gestaltet und auf das bzw. die Abschirmbleche angepasst. So ist gemäß einer bevorzugten Weiterbildung die Kammer auf einer Unterseite im Wesentlichen allein durch einen einteilig an dem Positionsrahmen ausgeformten Randsteg begrenzt. In Breitenrichtung ist der Positionsrahmen so dimensioniert, dass in dieser Breitenrichtung einander gegenüberliegende Randstege in das Schalenelement des unteren, d.h. ersten Abschirmblechs eingepasst sind. Die lichte Breite im Innern des Abschirmblechs auf Höhe der Randstege entspricht dementsprechend im Wesentlichen der Außenabmessung des Randsteges. Es verbleibt allerhöchstens ein geringer Spalt zwischen der Stirnseite des Randsteges und der Innenfläche, die durch den Längswandabschnitt des ersten Abschirmblechs gebildet ist. Der Spalt ist allerdings so bemessen, dass bei der zu erwartenden Kompression des aushärtenden Klebers beim Schließen der Abschirmung dieser Kleber nicht oder nur in einem geringen Maße die Kammer durch den Spalt verlassen kann. Der Randabschnitt befindet sich dabei üblicherweise am unteren Rand des Positionsrahmens. Auf der Oberfläche des Randabschnitts liegt üblicherweise auch die der Unterseite zugeordnete Isolierschicht auf dem Positionsrahmen und dem Randsteg auf. Durch diese Ausgestaltung ergibt sich eine innerhalb der Stirnseite des Randstegs liegende und von der Resthöhe des Positionsrahmens begrenzte Kammer. Der Randsteg kann eine Höhe entsprechend ein Viertel bis ein Sechstel der Höhe des Positionsrahmens haben. Oberhalb des Randstegs mag der Positionsrahmen eine nach innen abgehende Schrägfläche ausbilden, welche den Randsteg mit einem oberen Ende des Positionsrahmens begrenzt.

Die obige Beschreibung erfolgte in Breitenrichtung, d.h. in Ansehung einer Querschnittsansicht durch das längliche Wärme erzeugende Element. eine entsprechende Gestaltung sollte vorzugsweise auch in einer Längsschnittansicht zu sehen sein. Dementsprechend ist der umfänglich umlaufende Randsteg des Positionsrahmens umfänglich in das wannenförmige erste Abschirmblech in der oben beschriebenen Weise eingepasst, wodurch die Kammer oberhalb des Randstegs umfänglich nach unten begrenzt ist.

Sofern der erste Längswandabschnitt einen zweiten Längswandabschnitt des zweiten Abschirmblechs im Überlappungsbereich außenseitig fasst, begrenzt das zweite Abschirmblech, gegebenenfalls eine innen daran anliegende Isolierschicht oberseitig die Kammer, so dass in der Kammer befindlicher aushärtender Kleber die beiden Abschirmbleche dort miteinander verbindet und das von dem ersten Abschirmblech umfasste zweite Abschirmblech einsiegelt. Sofern die Abschirmbleche jeweils als im Wesentlichen umfänglich geschlossene Schalen ausgeformt sind, ergibt sich eine sichere Abschirmung sämtlicher elektrisch leitender und bestromter Elemente innerhalb der Abschirmung.

Mit der vorliegenden Erfindung wird ferner ein Verfahren nach Anspruch 7 zur Herstellung eines Wärme erzeugenden Elementes der eingangs genannten Art vorgeschlagen. Bei der Herstellung wird zunächst ein Abschirmblech mit schalenförmiger Ausgestaltung ausgeformt. Dieses Abschirmblech hat eine umfänglich umlaufende Längswand. In diese Schale wird zunächst eine erste, untere Isolierschicht sowie ein üblicherweise unmittelbar daran anliegendes unteres Kontaktblech eingelegt. Über dem Kontaktblech kommt das bzw. die PTC-Elemente zur Anlage an das untere Kontaktblech, wobei ein Positionsrahmen die PTC-Elemente außenseitig umgibt, wobei üblicherweise ein zumindest eine Aufnahme für wenigstens ein PTC-Element ausbildender Positionsrahmen gleichfalls in die Schale eingelegt wird. Auf der gegenüberliegenden Seite des PTC-Elementes wird ein zweites Kontaktblech aufgelegt.

Üblicherweise wird der Positionsrahmen zumindest zusammen den Kontaktblechen und dem PTC-Element als vormontierte Einheit vorbereitet, d.h. als solche in das schalenförmige erste Abschirmblech eingelegt. Die Bauteile können dabei mit dem Abschirmelement und/oder der ersten Isolierschicht verklebt werden, um diese zu positionieren. Anschließend wird zwischen einem Rand des ersten Abschirmblechs und dem Positionsrahmen ein flüssiger Kleber eingefüllt. Hernach wird bei dem erfindungsgemäßen Verfahren eines zweites Abschirmblech unter Zwischenlage einer zweiten Isolierschicht auf das weitere Kontaktblech aufgelegt und zwar derart, dass der Rand des zweiten Abschirmblechs in den flüssigen Kleber eindringt. Dieser erstarrt, so dass der Rand des zweiten Kontaktblechs über den erstarrten flüssigen Kleber eingesiegelt ist.

Beim Einbringen des Randes in den flüssigen Kleber wird dieser üblicherweise unter Druck gesetzt und verdrängt. Eventuelle Fehlstellen innerhalb der aufgebrachten Kleberaupe werden im Rahmen dieser Kompression ausgefüllt. Der flüssige Kleber wird üblicherweise als umfänglich umlaufende Kleberaupe in den Zwischenraum zwischen dem Positionsrahmen und dem Rand des ersten Abschirmblechs eingefüllt. Nach dem Aushärten des flüssigen Klebers ist der innerhalb der Abschirmung vorgesehene Bereich hermetisch abgeschlossen.

Die Menge des flüssigen Klebers wird vorzugsweise so eingestellt und zwischen dem Positionsrahmen und den ersten Abschirmblech eingefüllt, dass der Positionsrahmen vollumfänglich eingesiegelt wird, ohne dass der flüssige Kleber eines der Kontaktbleche und/oder das PTC-Element kontaktiert. Diese Elemente können dementsprechend bei Erwärmung bzw. Abkühlung Wärmedehnungen ausgleichen, ohne unmittelbar mit der Abschirmung bzw. unmittelbar diesen kontaktierenden Teilen in Berührung zu kommen. Bevorzugt wird der Kleber mit einem Volumen eingefüllt, das geringer als das Kammervolumen ist. So wird verhindert, dass bei einer Verdrängung des Klebers durch den Rand des weiteren Kontaktblechs soweit verdrängt wird, dass der Kleber zu dem PTC-Element und/oder den Kontaktblechen gelangt.

Üblicherweise bildet der Positionsrahmen einteilig daran angeformte Anschlussstutzen aus, welche die Abschirmung außenseitig überragen und Kanäle ausformen, in welche Kontaktstifte dichtend eingebracht werden können. Durch diese Maßnahme ist es möglich, das Wärme erzeugende Element im Innern zu kontaktieren bei gleichzeitiger Aufrechterhaltung der Versiegelung der elektrisch leitenden Teile des Wärme erzeugenden Elementes. Die besagten Anschlussstutzen können an ihrem Außenumfang ebenfalls eine Dichtung aufweisen, die es ermöglicht, das Wärme erzeugende Element in ein entsprechendes Anschlussgehäuse, beispielsweise ein Steuergehäuse einer elektrischen Heizvorrichtung abgedichtet einzusetzen.

Denn gemäß einer bevorzugten Weiterbildung der vorliegenden Erfindung wird das PTC-Element und/oder die daran anliegenden Kontaktbleche relativ zu dem Positionsrahmen so angeordnet, dass jeweils zumindest ein Luftspalt zwischen den freiliegenden Oberflächen der Kontaktbleche und des PTC-Elementes einerseits und dem Positionsrahmen andererseits verbleibt. Dieser Luftspalt wird an der Phasengrenze zwischen dem PTC-Element und dem Positionsrahmen lediglich punktuell durch Stützstellen durchbrochen, die üblicherweise von dem Positionsrahmen gebildet sind, die im Grunde geradlinig, d.h. rechtwinklig verlaufende und die Aufnahme begrenzende Wandungen des Positionsrahmens überragen und das wenigstens eine PTC-Element außenumfänglich abstützen. Die Stützstellen wirken punktuell gegen die Stirnseite des bzw. der PTC-Elemente.

Die vorliegende Erfindung schlägt des Weiteren ein fertigungstechnisch vereinfachtes Verfahren zur Herstellung eines Wärme erzeugenden Elementes bereit. Dieses Wärme erzeugende Element hat ein PTC-Element und zwei an gegenüberliegenden Seiten daran anliegende Kontaktbleche. Das Wärme erzeugende Element ist in einer Einhausung aufgenommen. Bei dieser Einhausung kann es sich um eine wie zuvor diskutierte Abschirmung handeln. Die Einhausung muss aber nicht zwingend gegenüber den Kontaktblechen elektrische isoliert vorgesehen sein und/oder Abschirmeigenschaften haben. Die Einhausung wird jedenfalls durch einen Kleber versiegelt. Diese Versiegelung kann beispielsweise durch Verbinden von Schalenelementen erfolgen. Versiegelt wird bei dem erfindungsgemäßen Verfahren jedenfalls eine Stelle, welche zum Einbringen und/oder Schließen eines Gehäuses der Einhausung dient. Das Gehäuse kann auch ein Rohr sein, in dem das PTC-Element und eines der Kontaktbleche gehalten sind. In diesem Fall kann das andere Kontaktblech durch einen Wandungsabschnitt des umfänglich geschlossenen Rohres gebildet sein. Erfindungsgemäß wird vorgeschlagen, den Kleber wärmehärtbar auszubilden und durch Wärme auszuhärten, welche durch Bestromen des Wärme erzeugenden Elementes erzeugt wird. Dementsprechend wird bei dem erfindungsgemäßen Verfahren auf den Durchlauf des montierten und mit dem Kleber versehenen Wärme erzeugenden Elementes durch einen Wärmeofen verzichtet. Es ist lediglich erforderlich, das vorbereitete Wärme erzeugende Element zu bestromen. Hierbei kann auch gleich eine Funktionsprüfung erfolgen, wodurch die für die Herstellung des Wärme erzeugenden Elementes erforderlichen Herstellungsschritte reduziert und vereinfacht sind.

Im Hinblick auf eine gute Durchwärmung haben die Abschirmbleche eine Blechstärke von üblicherweise 0,3 mm und weniger, wodurch das Wärmeaushärten des Klebers verbessert wird.

Vorzugsweise wird der Kleber wärmegehärtet bevor das Wärme erzeugende Element in eine Heizvorrichtung eingebaut wird. Die elektrische Heizvorrichtung hat hierbei üblicherweise einen Rahmen, der in der Regel mehrere in einem Schichtaufbau enthaltene Wärme erzeugende Elemente sowie beidseitig daran anliegende Wellrippenlagen umfänglich umschließt und Durchgangsöffnungen für den Durchtritt des zu erwärmenden Mediums bildet. In dieser Durchtrittsöffnung liegen üblicherweise zumindest die Wellrippenlagen frei.

Weitere Einzelheiten und Vorteile der vorliegenden Erfindung ergeben sich aus der nachfolgenden Beschreibung eines Ausführungsbeispiels in Verbindung mit der Zeichnung. In dieser zeigen:
- Figur 1: eine perspektivische Seitenansicht in Explosionsdarstellung eines Wärme erzeugenden Elementes;
- Figur 2: eine Querschnittsansicht des in Figur 1 gezeigten Wärme erzeugenden Elementes;
- Figur 3: eine Längsschnittansicht des in Figur 1 gezeigten Wärme erzeugenden Elementes;
- Figur 4: das Detail IV gemäß Figur 3 in vergrößerter Darstellung;
- Figur 5: das Detail V gemäß Figur 3 in vergrößerter Darstellung;
- Figur 6: eine Schnittansicht entlang der Linie VI - VI gemäß der Darstellung in Figur 3; und
- Figur 7: eine vergrößerte perspektivische Draufsicht auf ein stirnseitiges Ende des Wärme erzeugenden Elementes vor dem Auflegen des weiteren Abschirmblechs.

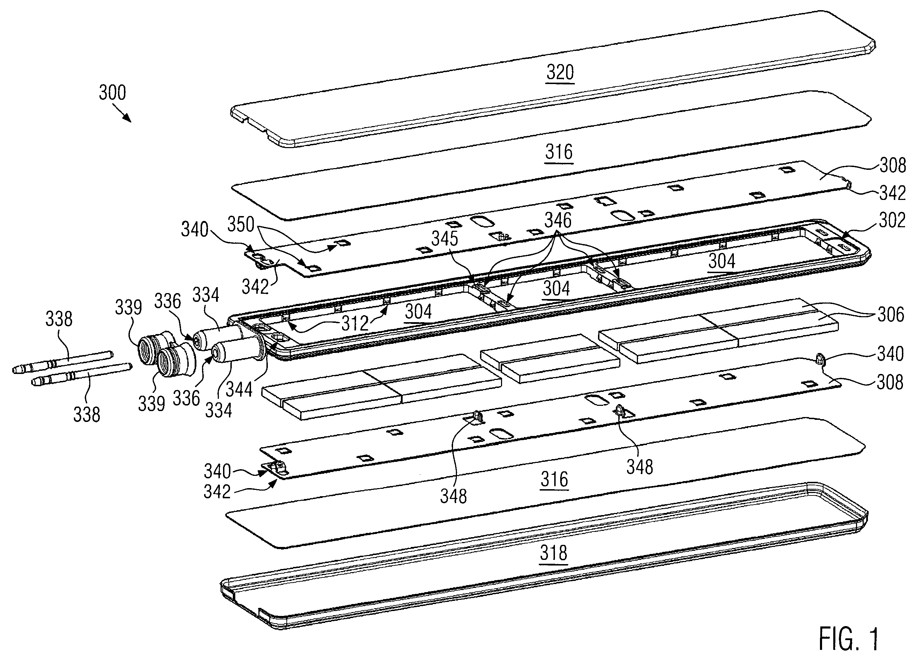

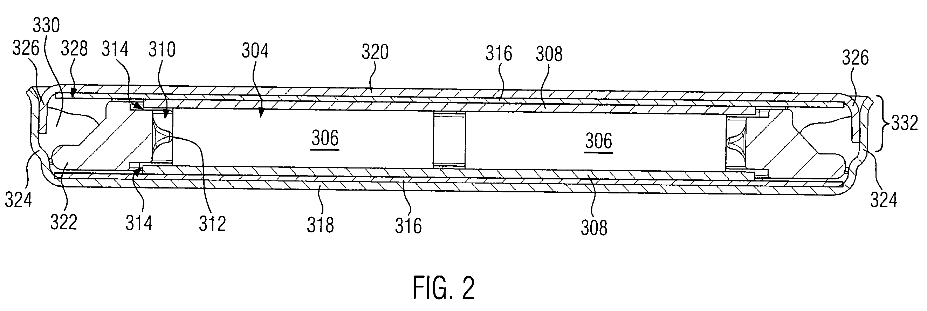

Wie insbesondere Figur 1 verdeutlicht, besteht ein dort gezeigtes Ausführungsbeispiel eines Wärme erzeugenden Elementes 300 aus mehreren übereinanderliegenden Schichten. Das Wärme erzeugende Element 300 ist im Wesentlichen symmetrisch aufgebaut, wobei in der Mitte ein mit Bezugszeichen 302 gekennzeichneter Positionsrahmen aus einem elektrisch isolierenden Material, insbesondere Kunststoff vorgesehen ist. Der Positionsrahmen 302 bildet Aufnahmen 304 für PTC-Elemente 306 aus. In einer Aufnahme 304 sind in Breitenrichtung zwei PTC-Elemente 306 aufgenommen (vgl. Fig. 2). An gegenüberliegenden Seiten der PTC-Elemente 306 liegen Kontaktbleche 308 an. Diese beiden Kontaktbleche 308 sind identisch ausgebildet und aus gestanztem elektrisch leitendem Blech ausgeformt. Die Kontaktbleche 308 sind als separate Elemente auf die PTC-Elemente 306 aufgelegt. Diese können zusätzlich mit einer aufgedampften Elektrodenschicht versehen sein, wie dies allgemein üblich ist. Die Elektrodenschicht ist indes nicht Kontaktblech 308 im Sinne der Erfindung.

Die Kontaktbleche 308 sind so dimensioniert, dass diese zwar innerhalb des Positionsrahmens 302 aufgenommen, jedoch umfänglich mit Abstand zu dem Positionsrahmen 302 angeordnet sind. Der insofern gebildete Umfangsspalt ist in Figur 2 mit Bezugszeichen 310 gekennzeichnet. Dieser Umfangsspalt 310 wird als Luftspalt zwischen dem Innenumfang der Aufnahme 304 und den darin vorgesehenen PTC-Elementen 306 gebildet und allein von in Höhen- und Breitenrichtung spitz zulaufenden Stützstellen 312 durchragt, die einteilig an dem Positionsrahmen 302 ausgeformt sind. Die Stützstellen 312 sind im Wesentlichen pyramidenförmig und jeweils mit Abstand zueinander an dem Innenumfang der Aufnahme 304 verteilt. Die Oberfläche der Stützstellen 312 ist zur Verlängerung der Kriechstrecke gekrümmt vorliegend konkav. Wie darüber hinaus Figur 2 verdeutlicht, halten auch die Kontaktbleche 308 über einen Luftspalt 314 jeweils Abstand zu dem Positionsrahmen 302. Dieser hat eine gestufte Ausgestaltung derart, dass ein innerer und die Aufnahme 304 begrenzender Bereich des Positionsrahmens 302 ausgeklinkt und nach innen versetzt ist. In diesem ausgeklinkten Bereich liegt der freie Rand der die PTC-Elemente 306 überragenden Kontaktbleche 308. Die Ober- und Unterseite des Positionsrahmens liegt üblicherweise unter Zwischenlage einer Isolierschicht 316 an Auflageflächen eines ersten Abschirmblechs 318 bzw. eines zweiten Abschirmblechs 320 an diesen an. Nachdem aber stets dafür Sorge zu tragen ist, dass in Höhenrichtung die Abschirmbleche 318, 320 unter Zwischenlage der Isolierschichten 316, der Kontaktbleche 308 und der PTC-Elemente 306 unmittelbar und mit guter Wärmeleitung aneinander anliegen kann es sein, dass der Positionsrahmen 302 eine geringere Höhe hat und dementsprechend auch gegenüber einer oder beiden Isolierschichten 316 beabstandet ist.

Der Positionsrahmen 302 bildet an seinem äußeren Rand einen umlaufenden Randsteg 322 aus, der eine Höhe von etwa einem Viertel des Positionsrahmens 302 hat. Auf Höhe des Randstegs 322 ist das schalenförmige erste Abschirmblech 318 so dimensioniert, dass der Positionsrahmen 302 mit seinem Randsteg 322 gerade zwischen einander gegenüberliegende Längswandabschnitte 324 passt, die vorliegend durch das erste Abschirmblech 318 ausgeformt sind. Oberhalb des Randstegs 322 ist das Blechmaterial des Abschirmblechs 318 leicht nach außen umbogen, erstreckt sich indes in Höhenrichtung. Das freie des Längswandabschnittes 324 ist trichterförmig nach außen gebogen.

Auch das zweite Abschirmblech 320 hat sich in Höhenrichtung erstreckende gegenüberliegende Längswandabschnitte 326. Diese liegen nach dem Fügen an der Innenfläche der Längswandabschnitte 324 an. Der zwischen den beiden Abschirmblechen 318, 320 und dem Positionsrahmen 302 zunächst gebildete Freiraum bildet eine Kammer 328 aus, in welcher Kleber 330 aufgenommen ist.

Der Kleber 330 ist in Umfangsrichtung um den Positionsrahmen 302 als Kleberaupe umlaufend ausgeformt und durch Erstarren einerseits mit dem Positionsrahmen 302 und andererseits mit den beiden Abschirmblechen 318, 320 verbunden. Entsprechendes gilt für die auf das zweite Abschirmblech 320 aufgelegte Isolierschicht 316, welche die Kammer 328 nach außen überragt. Wie indes Figur 2 zu entnehmen ist, ist der Kleber 330 so eingefüllt, dass er nicht bis zum Innern des Positionsrahmens 302 vordringt. Wie ersichtlich ist das Volumen des Klebers 330 geringer als das Volumen der Kammer 328. Der Kleber 330 ist bei dem gezeigten Ausführungsbeispiel lediglich mit dem Positionsrahmen 302 sowie den beiden Abschirmblechen 318, 320 verbunden. Freie Oberflächen der Kontaktbleche 308 und der PTC-Elemente 306 sind dementsprechend frei von Kleber 330, so dass der Kleber 330 nichts zu eventuellen Kriechstrecken beitragen kann. Durch den Kleber 330 ist die durch die beiden Abschirmblechen 318, 320 gebildete Abschirmung in einem Überlappbereich 332 der beiden Abschirmbleche 318, 320 versiegelt. Konkret taucht der Rand, d.h. bei der Querschnittsansicht nach Figur 2 der Längswandabschnitt 326 des zweiten Abschirmblechs 320 in die Kleberaupe ein und ist somit nach dem Aushärten des Klebers 330 in Umfangsrichtung dichtend eingesiegelt, so dass der innere Bereich der Abschirmung durch Verkleben der beiden Blechschalen 318, 320 versiegelt ist

Zugang zu dem Inneren des Positionsrahmens 302 geben allein an einer Stirnseite des Positionsrahmens 302 und durch dessen Material einteilig daran ausgebildete Anschlussstutzen 334, die einen Kanal 336 zur Aufnahme von stiftförmigen Kontaktelementen 338 voll umfänglich umgeben (vgl. Fig. 1). An ihrem freien Ende tragen die Anschlussstutzen 334 aus einem thermoplastischen Elastomer oder PTFE gebildete Dichtelemente mit labyrinthartiger Dichtstruktur 339, die durch Umspritzen oder Aufstecken mit dem zugehörigen Anschlussstutzen 334 verbunden sein können. An der Stirnseite jedes Positionsrahmens 302 sind zwei Anschlussstutzen 334 mit identischer Ausgestaltung und Abdichtung vorgesehen zur Aufnahme von zwei Kontaktstiften 338 zur elektrischen Kontaktierung der Kontaktbleche 308.

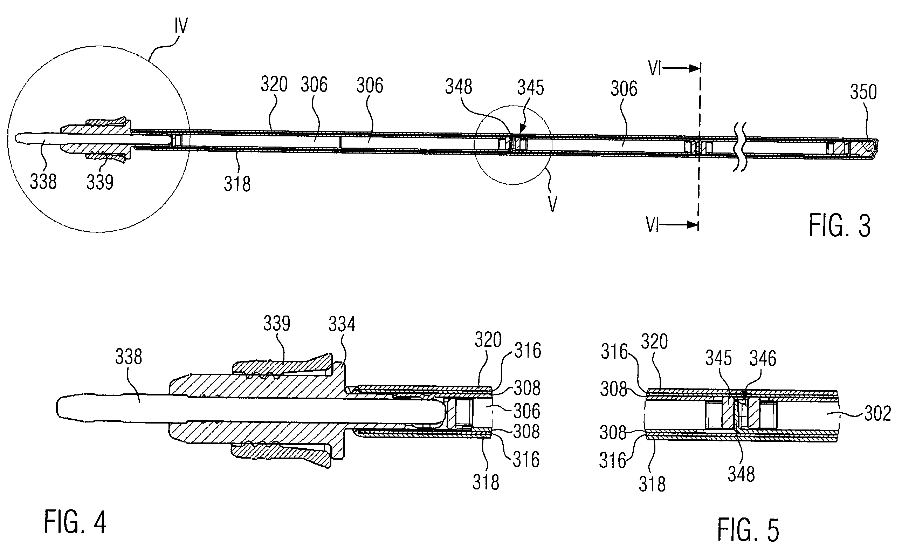

Wie weiterhin die Figuren 1 und 4 zu entnehmen ist, haben die Kontaktbleche 308 dazu mittels Stanzen und Biegen hergestellte weibliche Clipselementaufnahmen 340, die an seitlich versetzten Vorsprüngen 342 des Kontaktblechs 308 ausgeformt sind, welche Vorsprünge 342 innerhalb der durch den Kleber 330 gegebenen Umrandung enden und jeweils zugeordnete und durch den Positionsrahmen 302 ausgeformte Clipsöffnungen 344 überdecken. Die Kontaktstifte 338 liegen in den Clipsöffnungen 344 frei und sind mit den weiblichen Clipselementaufnahmen 340 der Kontaktbleche 308 verbunden. An der die Anschlussstutzen 334 aufweisenden Anschlussseite des Wärme erzeugenden Elementes 300 können die beschriebenen Clipsverbindungen entweder durch Positionieren der Kontaktbleche 308 in ihrer Einbaulage und nachfolgendes Einschieben der Kontaktstifte 338 durch die Kanäle 336 oder durch Verrasten der weiblichen Clipselementaufnahmen 340 mit den bereits in Position befindlichen Kontaktstiften 338 verwirklicht werden.

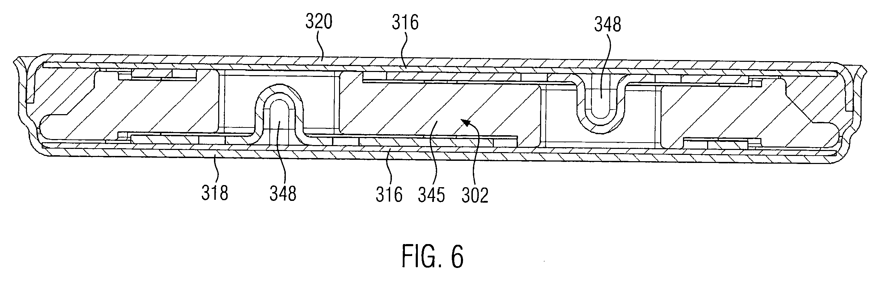

Der Positionsrahmen 302 weist an seinem stirnseitigen Ende und auch an Querstegen 345, die die einzelnen Aufnahmen 304 voneinander beabstanden, Verriegelungsöffnungen 346 auf, in welchen durch Stanzen und Biegen an dem Kontaktblech 308 ausgeformte Verriegelungszungen 348 im Eingriff sind, um das Kontaktblech 308 über seine gesamte Länge mit dem Positionsrahmen 302 zu verbinden (vgl. auch Fig. 5 und 6). Ferner sind an dem Kontaktblech 308 mehrere durch Freistanzen und Umbiegen ausgeformte Federzungen 350 ausgeformt, welche unter Vorspannung gegen die PTC-Element 306 zur Verbesserung der Kontaktierung anliegen (vgl. Fig. 1).

Bei der Herstellung des diskutierten Ausführungsbeispiels wird zunächst der aus Kunststoffspritzguss hergestellte Positionsrahmen 302 einseitig mit einem Kontaktblech 308 belegt. Das Kontaktblech 308 wird über die Verriegelungszungen 348 mit dem Positionsrahmen 302 verclipst. Auch verrastet das Kontaktblech 308 auf der Anschlussseite mit dem zugehörigen inneren Ende des Kontaktstiftes 338. In die auf solche Weise unterseitig geschlossene Aufnahme 304 werden nunmehr die PTC-Elemente 306 eingelegt. Danach wird das andere Kontaktblech 308 in der zuvor beschriebenen Weise auf den Positionsrahmen 302 aufgelegt und mit diesem verrastet.

Die Wärme erzeugende Zelle des Wärme erzeugenden Elementes ist damit als vormontierte Einheit fertig gestellt. Sie wird nunmehr in das erste wannenförmige Abschirmblech 318 eingelegt. Dessen Längswandabschnitt 324 ist an der Anschlussseite so modifiziert, dass die Kontaktstifte 338 berührungsfrei den Längswandabschnitt 324 passieren können.

Danach wird durch eine umlaufend verlegte Kleberaupe der Kleber 330 in die Kammer 328 eingefüllt. Die weitere Isolierschicht 316 wird aufgelegt. Des Weiteren wird das zweite Abschirmblech 320 aufgelegt und mit seinem umlaufenden Längswandabschnitt 326 in das erste schalenförmige Abschirmblech 318 eingepresst. Dabei wird der Kleber 330 geringfügig verdrängt und komprimiert. Der Kleber 330 umgibt jedenfalls das freie Ende des zweiten Abschirmblechs 320 und siegelt dieses zweite Abschirmblech 320 ein. Damit ist die durch die Abschirmbleche 318, 320 geformte Abschirmung hermetisch gegenüber der Atmosphäre versiegelt. Feuchtigkeit oder Verschmutzung können nicht ins Innere des Wärme erzeugenden Elementes 300 gelangen.

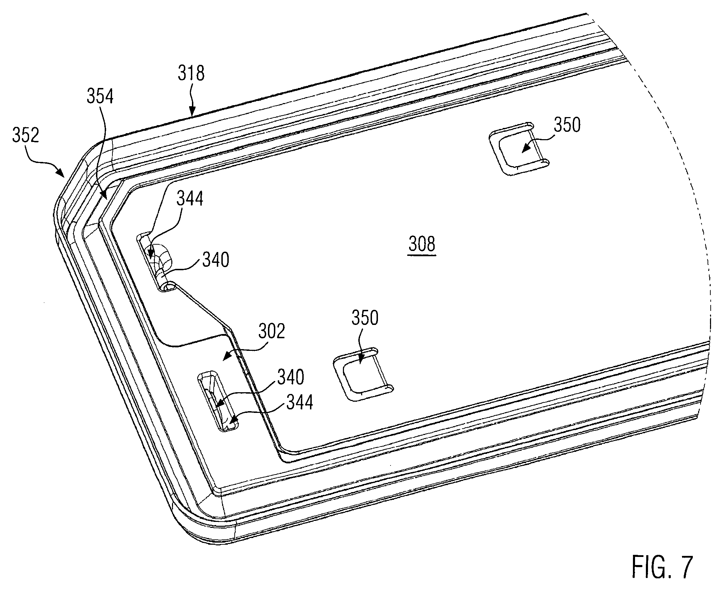

Wie Figur 7 verdeutlicht, sind das Abschirmblech 320 sowie der zugehörige Positionsrahmen 302 mit einander zugeordneten Positioniermitteln versehen, die bei dem gezeigten Ausführungsbeispiel durch eine abgeschrägte Ecke 352 des ersten Abschirmblechs 318 sowie einer zugeordneten abgeschrägten Ecke 354 des Positionsrahmens 302 gebildet sind. Durch diese Positioniermittel ist eine eindeutige Positionierung des bestückten Kontaktblechs 308 in dem ersten Abschirmblech 318 vorgegeben. Mit anderen Worten der Positionsrahmen 302 nur in der in Figur 6 gezeigten Ausrichtung in dem schalenförmigen ersten Abschirmblech 318 montiert werden. Es versteht sich von selbst, dass das zweite Abschirmblech 320 entsprechend ausgebildet ist und auch in der abgeschrägten Ecke 352 des ersten Abschirmblechs 318 in der zuvor beschrieben Weise in dieses eingreift und mit diesem überlappt.

### Bezugszeichenliste

- 300: Wärme erzeugendes Element
- 302: Positionsrahmen
- 304: Aufnahme
- 306: PTC-Element
- 308: Kontaktblech
- 310: Umfangsspalt
- 312: Vorsprung/Stützstelle
- 314: Luftspalt
- 316: Isolierschicht
- 318: erstes Abschirmblech
- 320: zweites Abschirmblech
- 322: Randsteg
- 324: Längswandabschnitt des ersten Abschirmblechs 318
- 326: Längswandabschnitt des zweiten Abschirmblechs 320
- 328: Kammer
- 330: Kleber
- 332: Überlappungsbereich
- 334: Anschlussstutzen
- 336: Kanal
- 338: Kontaktstift
- 339: Dichtelement
- 340: weibliche Clipselementaufnahme
- 342: versetzter Vorsprung
- 344: Clipsöffnung
- 345: Quersteg
- 346: Verriegelungsöffnung
- 348: Verriegelungszunge
- 350: Federzunge
- 352: abgeschrägte Ecke
- 354: abgeschrägte Ecke

## Patentansprüche

1. Wärme erzeugendes Element (300), insbesondere für eine elektrische Heizvorrichtung eines Kraftfahrzeuges, mit wenigstens einem PTC-Element (306) und zwei an gegenüberliegenden Seiten des PTC-Elementes (306) anliegenden Kontaktblechen (308), die an ihrer dem PTC-Element (306) abgewandten Außenseite mit einer Isolierschicht (316) versehen sind,
einer Abschirmung umfassend ein erstes schalenförmiges Abschirmblech (318) und ein zweites schalenförmiges Abschirmblech (320), die jeweils an der Außenseite der Isolierschicht (316) vorgesehen und mit dieser Wärme leitend gekoppelt sind, wobei aufeinander zugerichtete Längswandabschnitte (324, 326) des ersten und zweiten Abschirmblechs (318; 320) einen Überlappungsbereich (332) ausbilden, **dadurch gekennzeichnet,**
**dass** die beiden Abschirmbleche (318, 320) durch einen Kleber (330) versiegelt sind, der in einem der beiden Abschirmbleche (318) aufgenommen und in den ein Rand des anderen Abschirmblechs (320) endseitig eintaucht ist.

2. Wärme erzeugendes Element (300) nach Anspruch 1, **dadurch gekennzeichnet, dass** die beiden Abschirmbleche (318, 320) in dem Überlappungsbereich (332) miteinander kontaktiert sind.

3. Wärme erzeugendes Element (300) nach Anspruch 1 oder 2, **dadurch gekennzeichnet, dass** das Wärme erzeugende Element (300) mit der Abschirmung (318, 320) als vormontiertes Bauelement einer Heizvorrichtung ausgebildet ist.

4. Wärme erzeugendes Element (300) nach einem der vorherigen Ansprüche, **dadurch gekennzeichnet, dass** die Isolierschicht (316) einen eine Aufnahme (304) für das PTC-Element (306) ausbildenden Positionsrahmen (302) randseitig überragt und auf dem Positionsrahmen (302) aufliegt oder lediglich einen geringen Spalt (314) zur Kompensation von Fertigungstoleranzen zwischen sich und dem Positionsrahmen (302) freilässt.

5. Wärme erzeugendes Element (300) nach einem der vorherigen Ansprüche, **dadurch gekennzeichnet, dass** zwischen einem stirnseitigen Rand des Positionsrahmens (302) und dem ersten und dem zweiten Abschirmblech (318, 320) eine Kammer (328) gebildet ist, in der der Kleber (330) aufgenommen ist.

6. Wärme erzeugenden Element (300) nach einem der vorherigen Ansprüche, **dadurch gekennzeichnet, dass** die Kammer (328) auf einer Unterseite im Wesentlichen allein durch einen einteilig an dem Positionsrahmen (302) ausgeformten Randsteg (322) begrenzt ist und dass der Positionsrahmen (302) jedenfalls in Breitenrichtung so dimensioniert ist, dass in Breitenrichtung einander gegenüberliegende Randstege (322) zwischen einander gegenüberliegenden Längswandabschnitten (324) des ersten Abschirmblechs (318) eingepasst sind.

7. Verfahren zum Herstellen eines Wärme erzeugenden Elementes (300), bei dem zunächst in ein schalenförmiges erstes Abschirmblech (318) eine erste Isolierschicht (316) sowie ein Kontaktblech (308) mit einem innen daran anliegenden PTC-Element (306) eingelegt und auf der anderen Seite auf das PTC-Element (306) ein weiteres Kontaktblech (308) aufgelegt wird, danach innen in das erste Abschirmblech (318) ein flüssiger Kleber (330) eingefüllt wird und
danach ein zweites Abschirmblech (320) unter Zwischenlage einer zweiten Isolierschicht (316) auf das weitere Kontaktblech (308) aufgelegt wird, derart, dass der Rand des zweiten Abschirmbleches (320) in den flüssigen Kleber (330) eindringt.

8. Verfahren nach Anspruch 7, **dadurch gekennzeichnet, dass** ein das PTC-Element (306) umgebender Positionsrahmen (302) in das schalenförmige erste Abschirmblech (318) eingelegt wird, bevor auf der anderen Seite auf das PTC-Element (306) das weitere Kontaktblech (308) aufgelegt wird.

9. Verfahren nach Anspruch 8, **dadurch gekennzeichnet, dass** der Positionsrahmen (302) mit dem PTC-Element (306) und den beiderseitig daran anliegenden Kontaktblechen (308) als vormontierte Einheit in das erste Abschirmblech (318) eingelegt wird.

10. Verfahren nach Anspruch 8 oder 9, **dadurch gekennzeichnet, dass** das zweite Abschirmblechblech (320) so aufgelegt wird, dass das zweite Abschirmblech (320) das erste Abschirmblech (318) kontaktiert.

11. Verfahren nach einem der Ansprüche 8 bis 10, **dadurch gekennzeichnet, dass** eine solche Menge des flüssigen Klebers (330) zwischen dem Positionsrahmen (302) und dem ersten Abschirmblech (318) eingefüllt wird, dass der Positionsrahmen (302) vollumfänglich eingesiegelt wird, ohne dass der flüssige Kleber (330) eines der Kontaktbleche (308) und/oder das PTC-Element (306) kontaktiert.

12. Verfahren nach einem der Ansprüche 8 bis 11 **dadurch gekennzeichnet, dass** das PTC-Element (306) und/oder die daran anliegenden Kontaktbleche (306) so relativ zu dem Positionsrahmen (302) angeordnet werden, dass jeweils zumindest ein Luftspalt (310, 314) zwischen freiliegenden Oberflächen der Kontaktbleche (308) und/oder des PTC-Elementes (306) einerseits und dem Positionsrahmen (302) andererseits verbleibt, der lediglich durch punktuell das PTC-Element (306) außenumfänglich abstützende und von dem Positionsrahmen (302) gebildete Stützstellen (312) durchbrochen wird.

13. Verfahren
nach einem der
Ansprüche 7bis 12, **dadurch gekennzeichnet, dass** der Kleber (330) durch beim Bestromen des Wärme erzeugenden Elementes (300) erzeugte Wärme wärmegehärtet wird.

14. Verfahren nach Anspruch 13, **dadurch gekennzeichnet, dass** der Kleber (330) vor dem Einbau des Wärme erzeugenden Elementes (300) in eine Heizvorrichtung wärmegehärtet wird.

## Claims

1. Heat generating element (300), in particular for an electrical heating device of a motor vehicle, in particular for an electric heating device of a motor vehicle, with at least one PTC element (306) and two contact plates (308) which are in contact with opposite sides of said PTC element (306) and are provided on their outer side facing away from said PTC element (306) with an insulating layer (316), having shielding comprising a first shell-like shielding plate (318) and a second shell-like shielding plate (320) which are each provided on the outer side of said insulating layer (316) and are connected thereto in a thermally conductive manner, wherein longitudinal wall sections (324, 326), directed towards one another, of said first and second shielding plate (318; 320) form an overlapping region (332), **characterized in that** said two shielding plates (318, 320) are sealed by way of an adhesive (330) which is received in one of said two shielding plates (318) and into which the end of a rim of said other shielding plate (320) dips.

2. Heat generating element (300) according to claim 1, **characterized in that** said two shielding plates (318, 320) contact each other in said overlapping region (322).

3. Heat generating element (300) according to claim 1 or 2, **characterized in that** said heat generating element (300) is with said shielding (318, 320) formed as a prefabricated component of a heating device.

4. Heat generating element (300) according to one of the preceding claims, **characterized in that** said insulating layer (316) on the rim side extends beyond a positioning frame (302) forming a holding fixture (304) for said PTC element (306) and bears on said positioning frame (302) or leaves free only a small gap (314) between itself and said positioning frame (302) to compensate for manufacturing tolerances.

5. Heat generating element (300) according to one of the preceding claims, **characterized in that** a chamber (328) in which said adhesive (330) is received is formed between a face-side rim of said positioning frame (302) and said first and said second shielding plate (318, 320).

6. Heat generating element (300) according to one of the preceding claims, **characterized in that** said chamber (328) is at an underside defined substantially only by a rim web (322) formed integrally on said positioning frame (302) and that said positioning frame (302) is at least in the width direction dimensioned such that rim webs (322) in the width direction being oppositely disposed are fitted between oppositely disposed longitudinal wall sections (324) of said first shielding plate (318).

7. Method for producing a heat generating element (300), in which a first insulating layer (316) and a contact plate (308) having a PTC element (306) internally in contact therewith are first introduced into said shell-like first shielding plate (318), and a further contact plate (308) is placed on the other side onto said PTC element (306), a liquid adhesive (330) is then filled inside into said first shielding plate (318) and a second shielding plate (320) is then placed onto said further contact plate (308), with interposition of a second insulating layer (316), such that said rim of said second shielding plate (320) enters said liquid adhesive (330).

8. Method according to claim 7, **characterized in that** a positioning frame (302) surrounding said PTC element (306) is introduced into said shell-like first shielding plate (318) before said further contact plate (308) is placed onto the other side on said PTC element (306).

9. Method according to claim 8, **characterized in that** said positioning frame (302) with said PTC element (306) and said contact plates (308) bearing thereagainst on both sides are as a preassembled unit introduced into said first shielding plate (318).

10. Method according to claim 8 or 9, **characterized in that** said second shielding plate (320) is placed such that said second shielding plate (320) contacts said first shielding plate (318).

11. Method according to one of the claims 8 to 10, **characterized in that** an amount of said liquid adhesive (330) is filled in between said positioning frame (302) and said first shielding plate (318) such that said positioning frame (302) is entirely sealed without said liquid adhesive (330) contacting one of said contact plates (308) and/or said PTC element (306).

12. Method according to one of the claims 8 to 11, **characterized in that** said PTC element (306) and/or said contact plates (306) bearing thereagainst are arranged relative to said positioning frame (302) such that at least a respective air gap (310, 314) remains between exposed surfaces of said contact plates (308) and/or said PTC element (306), on the one hand, and said positioning frame (302), on the other hand, which is interrupted by support points (312) only at certain points supporting said PTC element (306) at the outer circumference and being formed by said positioning frame (302).

13. Method according to claims 7 to 12, **characterized in that** said adhesive (330) is cured with heat by heat generated when energizing said heat generating element (300).

14. Method according to claim 13, **characterized in that** said adhesive (330) is cured with heat prior to said heat generating element (300) being installed in a heating device.

## Revendications

1. Elément de production de chaleur (300), notamment destiné à un dispositif de chauffage électrique d'un véhicule automobile, comprenant au moins un élément PTC (306) (à coefficient de température positif) et deux tôles de contact (308), qui sont en appui sur deux côtés opposés de l'élément PTC (306), et qui, sur leur côté extérieur opposé à celui dirigé vers l'élément PTC (306), sont munis d'une couche d'isolation (316),
et un écran de blindage comportant une première tôle de blindage (318) en forme de coque et une deuxième tôle de blindage (320) en forme de coque, qui sont prévues respectivement sur le côté extérieur de la couche d'isolation (316) correspondante et sont couplées avec celle-ci sur le plan de la transmission de chaleur,
des tronçons de paroi longitudinale (324, 326) dirigés les uns vers les autres, de la première et de la deuxième tôle de blindage (318, 320), formant une zone de chevauchement réciproque (332),
**caractérisé**
**en ce que** les deux tôles de blindage (318, 320) sont scellées mutuellement par une colle (330), qui est reçue dans l'une des deux tôles de blindage (318) et dans laquelle plonge l'extrémité d'un bord de l'autre tôle de blindage (320).

2. Elément de production de chaleur (300) selon la revendication 1, **caractérisé en ce que** les deux tôles de blindage (318, 320) sont en contact réciproque l'une avec l'autre dans la zone de chevauchement (332).

3. Elément de production de chaleur (300) selon la revendication 1 ou la revendication 2, **caractérisé en ce que** l'élément de production de chaleur (300), avec son écran de blindage (318, 320), est réalisé en tant que module pré-monté d'un dispositif de chauffage.

4. Elément de production de chaleur (300) selon l'une des revendications précédentes, **caractérisé en ce que** la couche d'isolation (316) dépasse en bordure un cadre de positionnement (302) formant un logement (304) pour l'élément PTC (306), et repose sur le cadre de positionnement (302) ou laisse dégagé simplement un très faible interstice (314) pour la compensation de tolérances de fabrication entre elle et le cadre de positionnement (302).

5. Elément de production de chaleur (300) selon l'une des revendications précédentes, **caractérisé en ce qu'**entre un bord frontal du cadre de positionnement (302) et la première et la deuxième tôle de blindage (318, 320) est formée une chambre (328) dans laquelle est reçue la colle (330).

6. Elément de production de chaleur (300) selon l'une des revendications précédentes, **caractérisé en ce que** la chambre (328) est délimitée sur un côté inférieur, uniquement par une nervure de bordure (302) formée en appendice d'un seul tenant avec le cadre de positionnement (302), et **en ce que** le cadre de positionnement (302) est dimensionné, en tous les cas dans la direction de la largeur, de façon telle que des nervures de bordure (322) mutuellement opposées dans la direction de la largeur, soient ajustées entre deux tronçons de paroi longitudinale (324) mutuellement opposés de la première tôle de blindage (318).

7. Procédé de fabrication d'un élément de production de chaleur (300), d'après lequel on place tout d'abord dans une première tôle de blindage (318) en forme de coque, une première couche d'isolation (316) ainsi qu'une tôle de contact (308) avec un élément PTC (306) s'y appuyant à l'intérieur, et on dépose sur l'autre côté, sur l'élément PTC (306), une autre tôle de contact (308), puis on verse à l'intérieur dans la première tôle de blindage (318), une colle liquide (330), et
on dépose ensuite une deuxième tôle de blindage (320), avec interposition d'une deuxième couche d'isolation (316), sur ladite autre tôle de contact (308) de façon telle, que le bord de la deuxième tôle de blindage (320) s'engage dans la colle liquide (330).

8. Procédé selon la revendication 7, **caractérisé en ce que** l'on dépose un cadre de positionnement (302) entourant l'élément PTC (306), dans la première tôle de blindage (318) en forme de coque, avant de déposer sur l'autre côté, sur l'élément PTC (306), ladite autre tôle de contact (8).

9. Procédé selon la revendication 8, **caractérisé en ce que** le cadre de positionnement (302) est déposé avec l'élément PTC (306) et les tôles de contact (308) qui s'y appuient des deux côtés, en tant qu'unité pré-montée, dans la première tôle de blindage (318).

10. Procédé selon la revendication 8 ou la revendication 9, **caractérisé en ce que** la deuxième tôle de blindage (320) est déposée de façon telle que cette deuxième tôle de blindage (320) entre en contact avec la première tôle de blindage (318).

11. Procédé selon l'une des revendications 8 à 10, **caractérisé en ce que** l'on verse la colle liquide (330) entre le cadre de positionnement (302) et la première tôle de blindage (318) en quantité telle, que le cadre de positionnement (302) soit scellé sur la totalité de sa périphérie sans que la colle liquide (330) n'entre en contact avec l'une des tôles de contact (308) et/ou l'élément PTC (306).

12. Procédé selon l'une des revendications 8 à 11, **caractérisé en ce que** l'élément PTC (306) et/ou les tôles de contact (308), qui s'y appuient, sont agencés par rapport au cadre de positionnement (302) de manière à conserver respectivement au moins un interstice d'air (310, 314) entre des surfaces libres des tôles de contact (308) et/ou de l'élément PTC (306) d'une part et le cadre de positionnement (302) d'autre part, l'interstice n'étant interrompu que par des points d'appui (312) formés par le cadre de positionnement (302) et assurant un soutien ponctuel de l'élément PTC (306) à sa périphérie extérieure.

13. Procédé selon l'une des revendications 7 à 12, **caractérisé en ce que** la colle (330) est durcie thermiquement par de la chaleur produite par l'alimentation en courant de l'élément de production de chaleur (300).

14. Procédé selon la revendication 13, **caractérisé en ce que** la colle (330) est durcie thermiquement avant l'implantation de l'élément de production de chaleur (300) dans un dispositif de chauffage.
